# NEW EUROPEAN PATENT SPECIFICATION

(11) **EP 0 168 900 B2**
(45) Date of publication and mention of the opposition decision: **15.09.1993**
(45) Mention of the grant of the patent: 11.01.1989
(21) Application number: 85201199.8
(22) Date of filing: 10.05.1983
(51) Int. Cl.: H01R 9/09

(54) **Improved contact element and method of manufacture**
Kontaktelement und Verfahren zur Herstellung desselben
Elément de contact et sa méthode de fabrication

(30) Priority: 24.05.1982 US 381109
(43) Date of publication of application: 22.01.1986
(62) Divisional of application: 83302656.0
(73) Proprietor: AMP INCORPORATED (a New Jersey corporation), Harrisburg Pennsylvania 17105 (US)
(72) Inventor: Cobaugh, Robert Franklin, Deceased (US)
(74) Representative: Warren, Keith Stanley

(56) References cited:
- US-A- 3 634 819
- US-A- 3 783 433
- US-A- 4 066 326
- US-A- 4 186 982
- US-A- 4 206 964

## Description

This invention relates to an elongate contact element having a compliant section for receipt in a plated through hole in a printed circuit board to retain the contact element against movement, the compliant section comprising a split portion defining two legs extending longitudinally and offset along a shear plane provided by the splitting, the legs having been initially spread apart in opposite directions along a sheer plane to a spread apart position, and to a method of manufacture.

Such a contact element is disclosed in US-A-4 186 982, and a contact element having a compliant section of a different form has been disclosed in US-A-3 783 433.

The compliant sections of such contact elements are so structured as to yield upon being inserted into a plated through hole in a printed circuit board in such manner as to exert a strong force against the wall of the hole to retain the section therein but without destroying the wall and plating.

It is an object to provide an improved contact element of the type to which the invention relates in which hole distortion is lessened.

Accordingly a contact element of the type to which the invention relates is characterised in that the legs were then prestressed by pushing them back from said spread apart position to an extent that they remain offset with respect to each other along the shear plane, to resize the compliant section for its reception into the plated through hole.

The invention also includes the method of manufacture of a contact element of the type to which the invention relates which is characterised in that the legs are then prestressed by pushing the legs towards each other from said spread apart position along the shear plane to a predetermined relative position to an extent that they remain offset with respect to each other along the shear plane to resize the compliant section for its reception into the plated through hole.

The invention will now be described, by way of example, with reference to the accompanying partly diagrammatic drawings, in which:-
Figure 1 is an isometric view of a portion of a contact element including a compliant section and a stabilizer section added thereto,
Figure 2 is a cross-sectional view of a plated through hole in a printed circuit board showing the compliant section of the contact element of Figure 1 positioned therein,
Figures 3a and 3b are views taken along lines 3a-3a of Figure 2; and
Figures 4a, 4b, and 4c are cross-sectional views illustrating over-forming and resizing the compliant section of the contact element in accordance with the present invention.

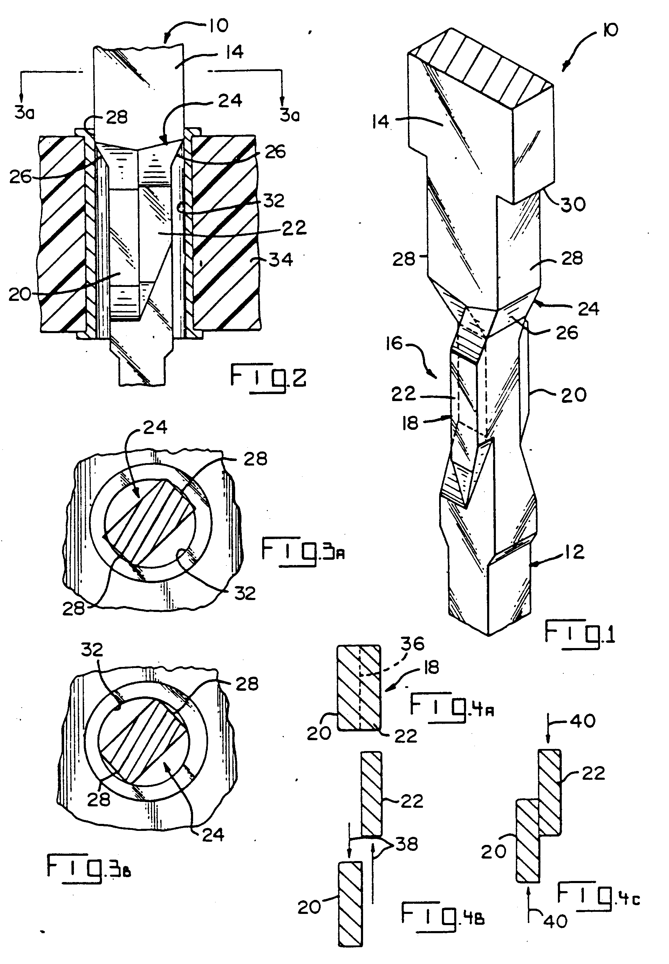

With reference to Figure 1, contact element 10 includes a lower section 12 which may be a post extending below a circuit board for wire wrapping or like purposes. Further, the element includes an upper section 14, of which only a small portion is shown, which may be a wire-wrap post, a spring-contact section for use in a card edge connector (not shown) or some other similar structure.

The compliant section is in between the aforementioned sections and is indicated generally by reference numeral 16. For an additional description of the compliant section, inquiry may be made to US Patent No. 4186 982. Generally, the compliant section includes a split portion 18, the split defining two legs 20 and 22. The legs are offset with respect to each other along the shear plane provided by the splitting.

A stabilizer section is located immediately above compliant section 16 and is indicated by a reference numeral 24. The section includes opposing bevelled or radiused surfaces 26 and sides 28 up to shoulders 30. Note that the stabilizer section is parallel to the shear plane separating legs 20 and 22. In other words, the bevelled surfaces are rotated ninety degrees relative to the direction in which the legs move. The bevelled surfaces are preferably at an angle of about thirty degrees relative to the vertical.

The critical dimension of the stabilizer section is the length of a diagonal line between opposing corners on sides 28. Ideally, that dimension will be equal to the diameter of the smallest or minimum plated through hole on a circuit board; i.e., the specified hole diameter less the permitted tolerance.

Figure 2 shows the compliant and stabilizer sections positioned in plated through hole 32 in circuit board 34. The drawing shows stabilizer section 24 engaging the wall of the plated through hole adjacent the top surface of board 34. The bevelled surfaces 26 facilitate the insertion particularly where hole 32 is undersized; i.e., of a minimum diameter. In this case, the bevelled surfaces and sides 28 will displace some of the plating as shown in Figure 3a. In extreme cases, the hole may be slightly distorted. Should the diameter of hole 32 be at a maximum diameter, sides 28 will just bear against the wall without disturbing the plating. This case is shown in Figure 3b. The provision of the stabilizer section forms the subject of EP-A-0095282 from which the present application is divided.

An improvement to contact element 10 involves compliant section 18. The improvement provides prestressing legs 20 and 22 by pushing them apart and then pushing them back towards each other to the desired size. Figures 4a, 4b and 4c illustrate the aforementioned improvement. Figure 4a shows the compliant section with a dashed line 36 being the slit forming legs 20 and 22. Thereafter, the legs are pushed apart in the direction of arrows 38 in Figure 4b and along the shear plane. The separation is preferably complete; i.e., the legs are completely separated one from the other. Lastly, the legs are pushed back towards each other as indicated by arrows 40 in Figure 4c; i.e., the legs are resized to a predetermined dimension.

The aforementioned improvement has provided substantially lower hole distortion and a significant decrease in force required to drive the contact element into the hole. Further, with the force required to insert a compliant section with resized legs being reduced the vulnerability of the contact elements to buckling is much less.

Tests show that the difference in force required to push an element out of a plated through hole is not measurably significant fora resized compliant section from that for an element without this improvement.

Further, tests have shown that the stabilizer section is very effective in returning the contact element to a vertical position after a deforming load was removed from an end. Also, the degree of movement did not increase over time during tests which subjected the elements to deforming loads in various directions. This indicates that the stabilizer section prevents cumulative loss in stability from multiple disturbances.

In summary, tests clearly indicate that contact elements incorporating the novel improvements disclosed herein cause less hole distortion, locks the elements in the hole as securely as for non-improved elements and has greater stability against deforming horizontal loads.

## Claims

1. An elongate contact element (10) having a compliant section (16) for receipt in a plated through hole (32) in a printed circuit board (34) to retain the contact element (10) against movement, the compliant section (16) comprising a split portion defining two legs (20) extending longitudinally and offset along a shear plane provided by the splitting, wherein the legs (20,22) were initially spread apart in opposite directions along the shear plane to a spread apart position, characterized in that the legs were then prestressed by pushing them back from said spread apart position to an extent that they remain offset with respect to each other along the shear plane, to resize the compliant section (16) for its reception into the plated through hole (32).

2. A method of manufacture of an elongate contact element (10) having a compliant section (16) for receipt in a plated through hole (32) in a printed circuit board (34) to retain the contact element (10) against movement, the compliant section (16) being formed by splitting the section along a shear plane to define two legs (20,22) which extend longitudinally and are spaced apart along the shear plane and by initially spreading the legs (20,22) apart along the shear plane to a spread apart position, characterized in that the legs (20,22) are then prestressed by pushing the legs towards each other from said spread apart position along the shear plane to a predetermined relative position to an extent that they remain offset with respect to each other along the shear plane to resize the compliant section (16) for its reception into the plated through hole (32).

## Patentansprüche

1. Längliches Kontaktelement (10) mit einem nachgiebigen Abschnitt (16) zur Aufnahme in einem durchplattierten Loch (32) in einer gedruckten Schaltungsplatte (34) zum Festhalten des Kontaktelements (10) gegen Ausführung einer Bewegung, wobei der nachgiebige Abschnitt (16) einen gespaltenen Bereich umfaßt, der zwei Schenkel (20) definiert, die sich in Längsrichtung erstrecken und längs einer durch die Spaltung geschaffenen Scherebene versetzt angeordnet sind, wobei die Schenkel (20, 22) anfangs längs der Scherebene in entgegengesetzten Richtungen in eine auseinandergespreizte Position auseinandergespreizt worden sind,
dadurch gekennzeichnet, daß die Schenkel dann vorgespannt worden sind, indem die Schenkel aus der auseinandergespreizten Position in einem derartigen Ausmaß zurückgedrückt werden, daß sie längs der Scherebene relativ zueinander versetzt bleiben, um den nachgiebigen Abschnitt (16) zur Aufnahme desselben in dem durchplattierten Loch (32) auf richtige Größe zurückzubringen.

2. Verfahren zum Herstellen eines länglichen Kontaktelements (10) mit einem nachgiebigen Abschnitt (16) zur Aufnahme in einem durchplattierten Loch (32) in einer gedruckten Schaltungsplatte (34) zum Festhalten des Kontaktelements (10) gegen Ausführung einer Bewegung, wobei der nachgiebige Abschnitt (16) gebildet wird durch Spalten desselben entlang einer Scherebene, so daß er zwei Schenkel (20, 22) definiert, die sich in Längsrichtung erstrecken und längs der Scherebene voneinander beabstandet sind, sowie durch anfangs erfolgendes Auseinanderspreizen der Schenkel (20, 22) längs der Scherebene in eine auseinandergespreizte Position,
dadurch gekennzeichnet, daß die Schenkel (20, 22) dann vorgespannt werden, indem die Schenkel längs der Scherebene aus der auseinandergespreizten Position bis auf eine vorbestimmte Relativposition in einem derartigen Ausmaß aufeinander zu gedrückt werden, daß sie längs der Scherebene relativ zueinander versetzt bleiben, um den nachgiebigen Abschnitt (16) zur Aufnahme desselben in dem durchplattierten Loch (32) auf richtige Größe zurückzubringen.

## Revendications

1. Elément de contact allongé (10) comportant une partie souple (16) destinée à être reçue dans un trou métallisé (32) d'une plaquette (34) à circuit imprimé de façon à s'opposer à tout mouvement de l'élément de contact (10), la partie souple (16) comprenant une portion fendue définissant deux branches (20) s'étendant longitudinalement et décalées suivant un plan de cisaillement établi par le fendage, les branches (20, 22) ayant été initialement écartées dans des directions opposées le long du plan de cisaillement jusqu'à une position écartée, caractérisé en ce que les branches ont ensuite été précontraintes en étant repoussées depuis ladite position écartée jusqu'à un point tel qu'elles restent décalées l'une par rapport à l'autre le long du plan de cisaillement, pourredimensionner la partie souple (16) poursa réception dans le trou métallisé (32).

2. Procédé de fabrication d'un élément de contact allongé (10) comportant une partie souple (16) destinée à être reçue dans un trou métallisé (32) d'une plaquette (34) à circuit imprimé afin de s'opposer à tout mouvement de l'élément de contact (10), la partie souple (16) étant formée par fendage de la partie suivant un plan de cisaillement afin de définir deux branches (20, 22) qui s'étendent longitudinalement et qui sont espacées l'une de l'autre suivant le plan de cisaillement, et par écartement initial des branches (20, 22) suivant le plan de cisaillement jusqu'à une position écartée, caractérisé en ce que les branches (20, 22) sont ensuite précontraintes en étant poussées l'une vers l'autre depuis ladite position écartée suivant le plan de cisaillement jusqu'à une position relative prédéterminée à un point tel qu'elles restent décalées l'une par rapport à l'autre suivant le plan de cisaillement pour redimen- sionner la partie souple (16) pour sa réception dans le trou métallisé (32).
